# EUROPEAN PATENT APPLICATION

(11) **EP 4 506 519 A1**
(43) Date of publication of application: **12.02.2025**
(21) Application number: 24191744.2
(22) Date of filing: 30.07.2024
(51) Int. Cl.: E04B 1/94, E04B 2/74, G06F 3/01, G06F 3/04815, G06F 3/04842, G06F 3/04845, G06F 30/13, G06Q 50/08, G06T 19/00, G06T 19/20

(54) **FIREPROOF PARTITION AND INSTALLING METHOD THEREOF**

(30) Priority: 11.08.2023 US 202363532104 P
(71) Applicant: Chou, Vicki-Fen, Zhongli Taoyuan City 320 (TW); Trinh, Philip, Zhongli Taoyuan City 320 (TW); Trinh, Christine, Zhongli Taoyuan City 320 (TW)
(72) Inventor: CHOU, Song, 320 Taoyuan City (TW)
(74) Representative: Charrier Rapp & Liebau

(57) **Abstract**

Provided is a fireproof partition including: two fireproof boards made of a fireproof material; a support board disposed between the two fireproof boards; a fixing means for fixing the two fireproof boards to two opposing sides of the support board respectively, allowing the support board to be sandwiched between the two fireproof boards; and a hanging means provided on an outer side of one of the two fireproof boards and adapted to operate in conjunction with a building.

## Description

### BACKGROUND OF THE INVENTION

### FIELD OF THE INVENTION

The present disclosure relates to a fireproof partition.

### DESCRIPTION OF THE PRIOR ART

The purpose of fireproof partitions is to stop smoke and flames from spreading during a fire. Every conventional fireproof partition usually consists of one single fireproof board, for example, calcium silicate board, gypsum board, and cement board. However, conventional fireproof boards are not only vulnerable to impacts but also poor in sound insulation.

In addition, conventional fireproof partitions are heavy. As a result, installation of conventional fireproof partitions can only be carried out under a force of great strength and thus is laborious.

### SUMMARY OF THE INVENTION

In view of the aforesaid drawbacks of the prior art, it is an objective of the disclosure to provide a fireproof partition that exhibits satisfactory fireproof effect and mechanical strength.

To achieve the above and other objectives, the disclosure provides a fireproof partition, comprising: two fireproof boards made of a fireproof material; a support board disposed between the two fireproof boards; a fixing means for fixing the two fireproof boards to two opposing sides of the support board respectively, allowing the support board to be sandwiched between the two fireproof boards; and a hanging means provided on an outer side of one of the two fireproof boards and adapted to operate in conjunction with a building.

In a specific embodiment, the support board has a non-planar surface.

In a specific embodiment, the fixing means involves coating an adhesive on the two opposing sides of the support board, allowing the support board to be coupled to and fixed to the two fireproof boards.

In a specific embodiment, each of the two fireproof boards has an inner side and an outer side, with the inner sides facing the support board and being of greater roughness than the outer sides.

In a specific embodiment, the two fireproof boards and each of the support board has a plurality of perforations, and the fixing means allows the support board to be coupled to and fixed to the two fireproof boards through multiple fastening elements that engage with the perforations of the two fireproof boards and the perforations of the support board.

In a specific embodiment, the fastening elements include a bolt and a threaded insert, and an end of the bolt is provided with the hanging means.

In a specific embodiment, one of the two fireproof boards has an opening, with the hanging means being provided to the support board and exposed from the fireproof board through the opening, allowing the hanging means to operate in conjunction with the building.

In a specific embodiment, the fireproof partition further comprises a plurality of securing elements disposed on the fireproof partition, the securing elements including a bolt and a threaded insert, with the hanging means being provided to an end of the bolt to operate in conjunction with the building.

Another objective of the disclosure is to provide a method of installing a fireproof partition to enhance the ease of installing the fireproof partition on a building structure.

To achieve the above and other objectives, the disclosure further provides a method of installing a fireproof partition, the method comprising the steps of: providing a support board and two fireproof boards, allowing the support board to be sandwiched between the two fireproof boards through a fixing means so as to form a fireproof partition; providing a hanging means on an outer side of one of the two fireproof boards; and enabling the fireproof partition to engage with a wall semifinished product of a building through the hanging means, allowing the fireproof partition to hang on the wall semifinished product.

In a specific embodiment, the wall semifinished product includes a steel plate and a plurality of C-shaped steel bars connected to the steel plate, the method further comprising the step of providing a hook at an end of each of the C-shaped steel bars, with the hooks being configured to operate in conjunction with the hanging means to allow the fireproof partition to hang on the C-shaped steel bars.

In a specific embodiment, the method further comprises the step of providing a plurality of securing elements functioning as the hanging means and disposed on an outer side of one of the two fireproof boards.

In a specific embodiment, an opening is formed on one of the two fireproof boards, and the hanging means is exposed from the fireproof board through the opening.

In a specific embodiment, the fixing means involves coating an adhesive on two opposing sides of the support board, allowing the support board to be coupled to and fixed to the two fireproof boards.

In a specific embodiment, the fixing means involves providing a plurality of fastening elements, allowing the support board to be coupled to and fixed to the two fireproof boards.

### BRIEF DESCRIPTION OF THE DRAWINGS

FIG. 1 is an exploded view of a fireproof partition according to an embodiment of the disclosure.
FIG. 2 is a cross-sectional view of the fireproof partition taken along line A-A of FIG. 1.
FIG. 3 depicts a first method of installing the fireproof partition according to an embodiment of the disclosure.
FIG. 4 depicts a second method of installing the fireproof partition according to an embodiment of the disclosure.
FIG. 5 depicts a third method of installing the fireproof partition according to an embodiment of the disclosure.
FIG. 6A depicts a fourth method of installing the fireproof partition according to an embodiment of the disclosure.
FIG. 6B is a schematic perspective view of a support board in FIG. 6A.
FIG. 7 is a schematic view of the fireproof partition connected to another fireproof partition according to an embodiment of the disclosure.
FIG. 8 depicts a means of hanging fireproof partitions on two sides of C-shaped steel bars according to an embodiment of the disclosure.
FIG. 9 is a schematic view of an example of installing multiple fireproof partitions according to an embodiment of the disclosure.
FIG. 10 depicts a fifth method of installing the fireproof partition according to another embodiment of the disclosure.
FIG. 11 is a schematic view of a process flow of a method of installing a fireproof partition according to an embodiment of the disclosure.

**DETAILED DESCRIPTION OF THE EMBODIMENTS**

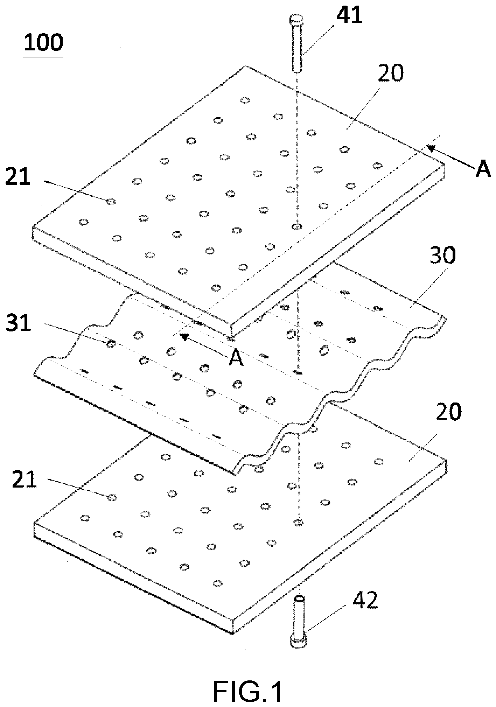

FIG. 1 is an exploded view of a fireproof partition 100 according to an embodiment of the disclosure. The fireproof partition 100 provided by the disclosure essentially comprises a support board 30 and two fireproof boards 20.

The support board 30 is disposed between the two fireproof boards 20 to serve as the major supporting structure of the fireproof partition 100 to reinforce the fireproof partition 100 and protect it against damage. The support board 30 is formed by shaping a steel plate and has a non-planar surface. Thus, the cross-sectional profile of the support board 30 is not linear but is, for example, wavy or V-shaped, to enhance the mechanical strength of the fireproof partition 100. Preferably, the support board 30 is formed from a steel plate with a thickness of 2 mm.

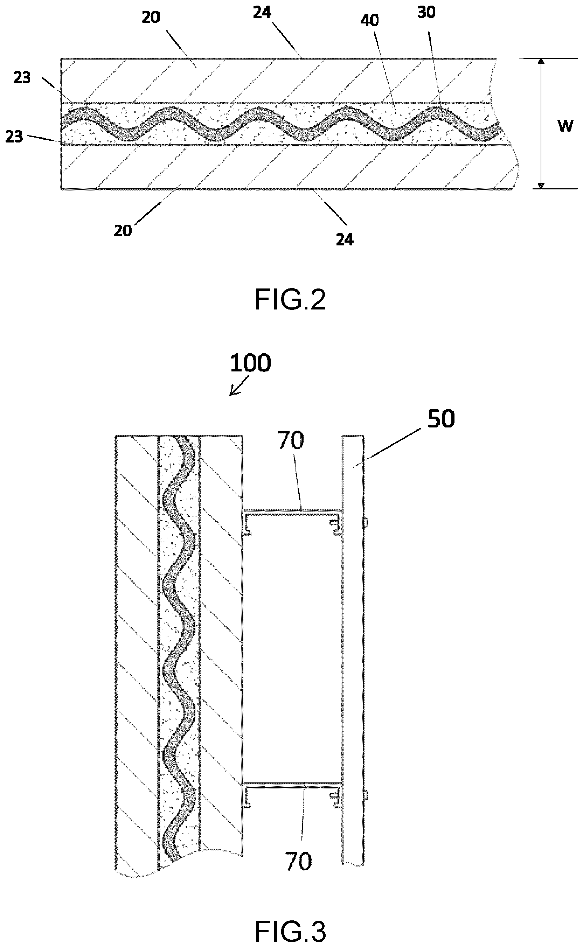

The fireproof boards 20 are made of a fireproof material, for example, calcium silicate or any A class fireproof material. As shown in FIG. 2, Each of the fireproof boards 20 has an inner side 23 and an outer side 24. The inner sides 23 face the support board 30. The outer sides 24 may serve as outer surfaces of walls and have surface-treated layers, for example, coating layers, patterned printed layers and protective layers, to enhance beauty or augment fireproof effect.

The fireproof boards 20 and the support board 30 are fixed to each other through multiple fixing means or any conventional fixation techniques by fixing the two fireproof boards 20 to the two opposing sides of the support board 30 and allowing the support board 30 to be sandwiched between the two fireproof boards 20. As shown in FIG. 1, perforations 21, 31 are formed in the fireproof boards 20 and the support board 30. A fixing means consists of multiple fastening elements, the perforations 21 of the two fireproof boards 20, and the perforations 31 of the support board 30, allowing the two fireproof boards 20 and the support board 30 to be fixedly coupled together. The fastening elements include but are not limited to a combination of a threaded insert 42 and a bolt 41 or achieve fastening merely through screws. The perforations 21, 31 are disposed on the fireproof boards 20 and the support board 30 in advance. Alternatively, screws penetrate the fireproof boards 20 and the support board 30 directly to form the perforations 21, 31 to meet fixation needs.

As shown in FIG. 2, the two opposing sides of the support board 30 are coated with an adhesive 40 such that the inner sides 23 of the fireproof boards 20 are firmly adhered to the support board 30. Furthermore, the fireproof boards 20 and the support board 30 are fixedly coupled together through the fastening elements and the adhesive 40.

Preferably, the non-planar surface of the support board 30 is conducive to an increase in the contact surface area of the adhesive 40 to allow the fireproof boards 20 to be firmly coupled to the support board 30. Alternatively, owing to the surface treatment performed on outer sides 24 of the fireproof boards 20, the inner sides 23 of the fireproof boards 20 are of greater roughness than the outer sides 24 of the fireproof boards 20, the large surface area of contact between the adhesive 40 and each of the inner sides 23 of the fireproof boards 20 is conducive to an increase in the adhesion between the support board 30 and each of the fireproof boards 20. Preferably, the fireproof partition 100 has a thickness W of around 8.0 mm.

FIG. 3 depicts how the fireproof partition 100 is installed on an unfinished outer or inner wall of a building. As shown in FIG. 3, a wall semifinished product of the building comprises a steel plate 50. One side of the steel plate 50 has a surface-treated layer, such as coating layer, pigment layer, and protective layer. A plurality of C-shaped steel bars 70 (i.e. steel channels) are fixed to the other side of the steel plate 50 and spaced apart from each other in the vertical direction. The C-shaped steel bars 70 extend horizontally and are parallel. The fireproof partition 100 is provided with a hanging means laterally and thereby connected to the C-shaped steel bars appropriately; thus, the fireproof partition 100 becomes part of the building's wall, as shown in FIG. 3, allowing one end of each C-shaped steel bar 70 to fixedly connect to the steel plate 50 through a screw and the other end to the fireproof partition 100 through a screw. In another embodiment, the C-shaped steel bars 70 extend vertically and are spaced apart from each other horizontally.

The disclosure provides a hanging means to the C-shaped steel bars 70 and the fireproof partition 100 to enable the fireproof partition 100 to be removably connected to the C-shaped steel bars 70. One end of each C-shaped steel bar 70 is fixedly connected to the steel plate 50 through a known fixing means, for example, a screw and a nut. The fireproof partition 100 is provided with a hanging means. The other end of each C-shaped steel bar 70 has a hook 71, and the hooks 71 are configured to operate in conjunction with the hanging means; thus, the fireproof partition 100 can hang on the C-shaped steel bars 70, allowing the fireproof partition 100 to be removably connected to the C-shaped steel bars 70. In another embodiment, the hanging means has a wedge-shaped structure corresponding in shape to the hooks 71, and the wedge-shaped structures of the hanging means 62, 33, 34 are inserted into the hooks 71, or the hanging means 62, 33, 34 engage the hooks 71, allowing the fireproof partition 100 to connect to the C-shaped steel bars 70.

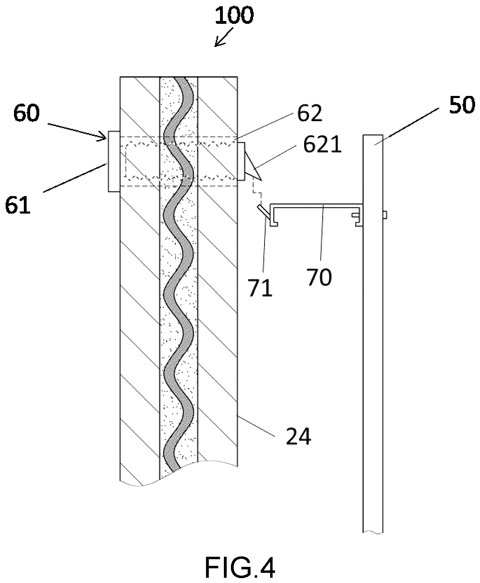

FIG. 4 exemplarily illustrates a means of coupling the fireproof partition 100 and the C-shaped steel bars 70 together. One end of each C-shaped steel bar 70 is fixedly connected to the steel plate 50 by a known fixing means, for example, a screw and a nut. The other end of each C-shaped steel bar 70 has the hook 71. The fireproof partition 100 has a plurality of securing elements 60. The securing elements 60 include threaded inserts 61 and bolts 62. A connection portion 621 is disposed at one end of each of the bolts 62 to function as a hanging means. The connection portions 621 operate in conjunction with the hooks 71, allowing the fireproof partition 100 to be removably connected to the C-shaped steel bars 70. A replacement process merely entails lifting and removing the fireproof partition 100 from the hooks 71. Each of the securing elements 60 includes the bolt 41 and the threaded insert 42 in the aforesaid fixing means; thus, not only are the threaded inserts 42 and the bolts 41 passed through the perforations to allow the support board 30 to be fixedly coupled to the fireproof boards 20, but the bolts 41 also operate in conjunction with the connection portions 621 to provide a hanging means whereby the fireproof partition 100 is connected to the C-shaped steel bars 70. In a variant embodiment, each of the securing elements 60 includes components different from the bolt 41 and the threaded insert 42 in the fixing means, and the components are additionally disposed at specific positions of the fireproof partition 100 as needed.

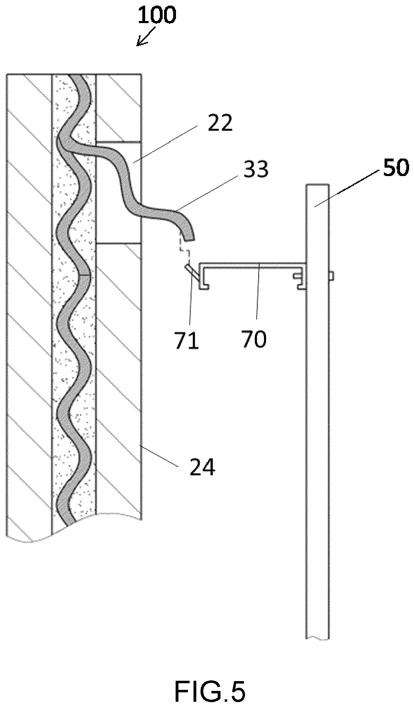

FIG. 5 exemplarily illustrates another hanging means for use with the fireproof partition 100 and the C-shaped steel bars 70. After the support board 30 has been shaped and formed, one side of the support board 30 is incised at one or more points, and then the one or more incisions are bent to form one or more tabs 33 respectively for functioning as a hanging means, or the one or more tabs 33 are welded to one side of the support board 30 to function as a hanging means. Openings 22 are formed on the fireproof boards 20 and correspond in position to the tabs 33 respectively to allow the tabs 33 to extend outward from the support board 30 and protrude from the fireproof boards 20, allowing the outermost ends of the tabs 33 to protrude from the outer sides 24 of the fireproof boards 20. Therefore, with the tabs 33 engaging the hooks 71 of the C-shaped steel bars 70, the fireproof partition 100 can hang on the building's wall. A replacement process merely entails lifting and removing the fireproof partition 100 from the hooks 71.

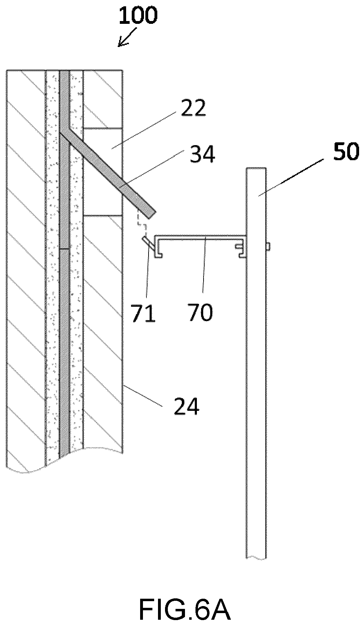

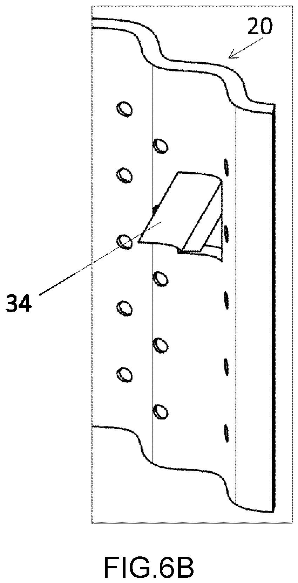

FIG. 6 exemplarily illustrates another hanging means for use with the fireproof partition 100 and the C-shaped steel bars 70. The support board 30 is incised at one or more points in the direction shown in FIG. 6B, and then the one or more incisions are bent to form one or more tabs 34 respectively for functioning as a hanging means, or the one or more tabs 34 are welded to one side of the support board 30 to function as a hanging means. The openings 22 are formed on the fireproof boards 20 and correspond in position to the tabs 34 respectively to allow the tabs 34 to extend outward from the support board 30 and protrude from the fireproof boards 20, allowing the outermost ends of the tabs 34 to protrude from the outer sides 24 of the fireproof boards 20. Therefore, with the tabs 34 engaging the hooks 71 of the C-shaped steel bars 70, the fireproof partition 100 can hang on the building's wall. A replacement process merely entails lifting and removing the fireproof partition 100 from the hooks 71.

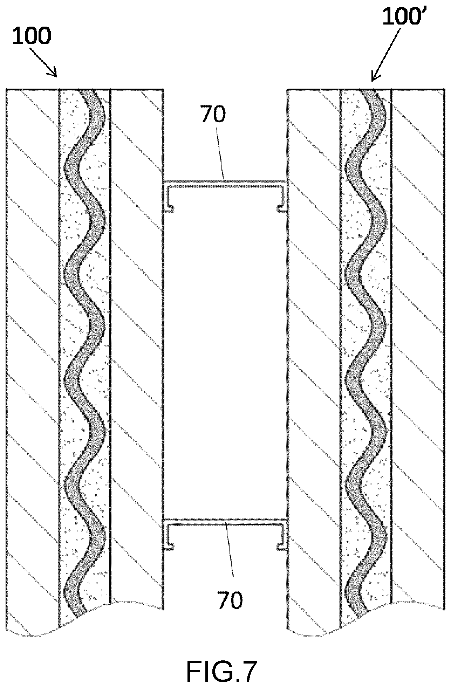

FIG. 7 exemplarily illustrates another hanging means for use with the fireproof partition 100 and another fireproof partition 100'. Unlike the preceding embodiments in which the fireproof partition 100 is fixed to or hung on the building's wall, the fireproof partition 100 of this embodiment is fixed to or hung on the other fireproof partition 100' through the C-shaped steel bars 70. First, the C-shaped steel bars 70 (functioning as beams) are fixed in position at different heights by a known means (for example, columns), and the fireproof partition 100' is hung on one side of each of the C-shaped steel bars 70 through the hanging means provided on one side thereof. Alternatively, a screw and a nut together substitute for the hanging means. The fireproof partition 100 is hung on the other side of each of the C-shaped steel bars 70 through the hanging means. Like what is disclosed in the preceding embodiments, the fireproof partitions 100 and 100' are provided with a hanging means, with the hook 71 being disposed on the other end of each of the C-shaped steel bars 70 and configured to operate in conjunction with the hanging means, the fireproof partitions 100 and 100' can be removably connected to the C-shaped steel bars 70, allowing the fireproof partition 100 and the fireproof partition 100' to be fitted and connected to each other.

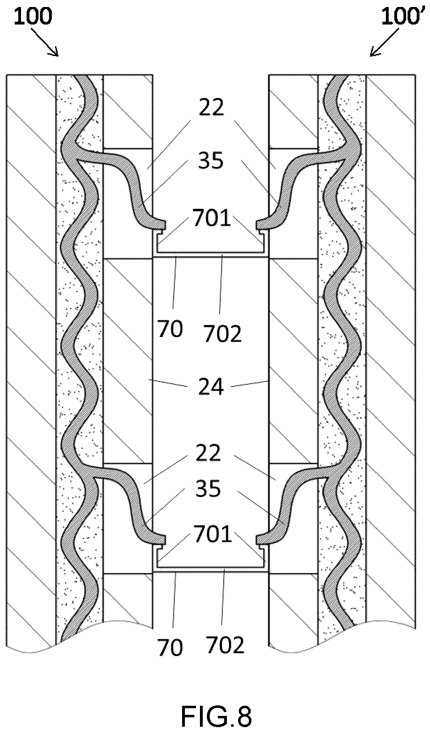

FIG. 8 exemplarily illustrates a hanging means for hanging the fireproof partition 100 and the fireproof partition 100' on two sides of the C-shaped steel bars 70 respectively. In this embodiment, the fireproof partitions 100 and 100' are hung on two sides of the C-shaped steel bars 70 respectively. First, the C-shaped steel bars 70 (functioning as beams) are fixed in position at different heights by a known means (for example, columns). Unlike the preceding embodiments, this embodiment has distinguishing technical features as follows: the C-shaped steel bars 70 are fixed in place invertedly, and thus a long side 702 of each C-shaped steel bar 70 is closer to the floor than a short side 701 of each C-shaped steel bar 70. The fireproof partitions 100 and 100' are provided with the hanging means shown in FIG. 5, and the hanging means involves using, as disclosed in the preceding embodiments, tabs 35 extending from the support board 30, or a connection portion (not shown) disposed on the additionally installed securing elements and hung on the short sides 701 of the C-shaped steel bars 70, allowing the fireproof partitions 100 and 100' to be removably connected to the C-shaped steel bars 70.

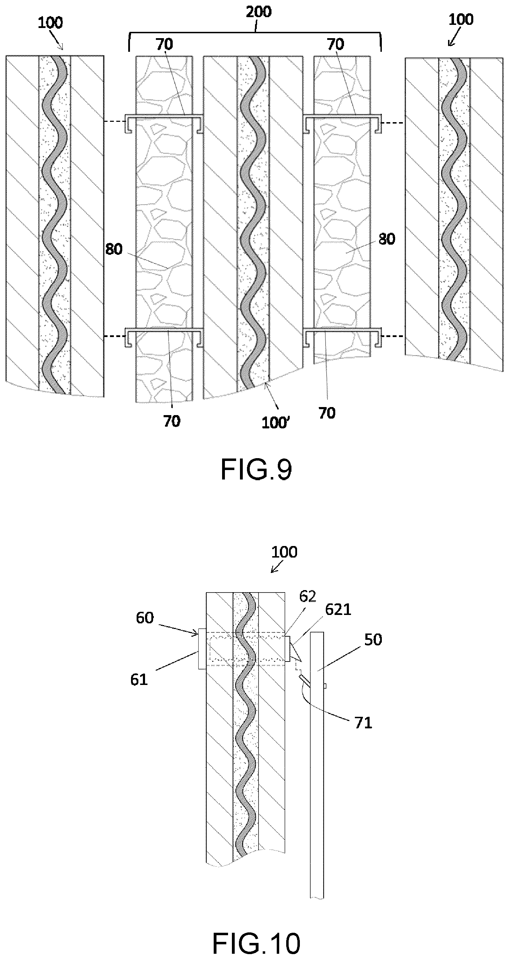

FIG. 9 exemplarily illustrates another hanging means for use with the fireproof partition 100 and the fireproof partition 100'. The C-shaped steel bars 70 are disposed on the two opposing sides of the fireproof partition 100' respectively. Two C-shaped steel bars 70 are fixed in place at different heights, and then the fireproof partition 100' is sandwiched between the two C-shaped steel bars 70. The C-shaped steel bars 70 are connected to the fireproof partition 100' through the hanging means. Alternatively, one end of each of the C-shaped steel bars 70 is fixedly connected to the fireproof partition 100' through a known fixing means, for example, a screw and a nut. The fireproof partition 100' and the C-shaped steel bars 70 disposed on the two opposing sides of the fireproof partition 100' can form a building structure component 200, allowing the fireproof partition 100 to be connected to the building structure component 200. Specifically speaking, the other side of each of the C-shaped steel bars 70 of the building structure component 200 is connected to the fireproof partition 100 through the same hanging means or a known fixing means. Like what is disclosed in the preceding embodiments, the fireproof partition 100 is provided with a hanging means, with the hook 71 being disposed at the other end of each of the C-shaped steel bars 70 and configured to operate in conjunction with the hanging means, the fireproof partition 100 can be removably connected to the C-shaped steel bars 70, allowing the two fireproof partitions 100 and the fireproof partition 100' hung on two opposing sides of the two fireproof partitions 100 to form a wall of a thickness. Preferably, a sound-insulating material 80 is filled in between (not shown) the fireproof partition 100' and the fireproof partition 100 or in between (not shown) the steel plate 50 and the fireproof partition 100 to effectively achieve sound absorption or sound insulation.

According to the disclosure, the method of installing the fireproof partition 100 enables the fireproof partition 100 to be removably connected to the C-shaped steel bars 70 and thereby easily replaced or pre-installed as needed. Furthermore, the hanging means of the fireproof partition 100 is connected to the hooks 71 in advance, and thus any subsequent process of fixedly connecting the fireproof partition 100 to the C-shaped steel bars 70 is easy, rendering the installation of the fireproof partition 100 easy.

FIG. 10 illustrates yet another embodiment of the present invention. Instead of providing the hooks 71 on the C-shaped steel bars 70, the hooks 71 may be mounted directly onto the steel plate 50 or other similar wall structure without using the C-shaped steel bars 70. Said hook 71 might be combined with a known suitable mounting component, such as a bolt, so as to be mounted on the wall structure with a sufficient supportive strength. In this way, the fireproof partition 100 can be hung on the steel plate 50 by engaging the connection portions 621 with the hooks 71. In comparison, this embodiment without using the C-shaped steel bars 70 allows the fireproof partition 100 to be more close to the surface of steel plate 50, which means the space between the fireproof partition 100 and the steel plate 50 is more reduced, and therefore the thickness of the final wall can be smaller.

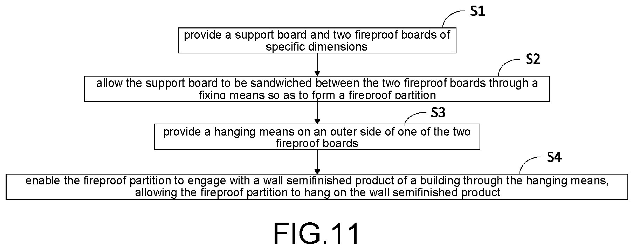

FIG. 11 is a schematic view of a process flow of a method of installing the fireproof partition 100 according to an embodiment of the disclosure. The method of installing the fireproof partition 100 comprises the steps as follows: Step S1: providing a support board 30 and a pair of fireproof boards 20 (i.e., two fireproof boards 20) of specific dimensions, wherein the support board 30 and the fireproof boards 20 are of substantially identical or similar dimensions, or the dimensions of the support board 30 are slightly less than the dimensions of the fireproof boards 20. The steel plate 50 is shaped to provide the support board 30 having a non-planar surface. For example, the support board 30 has a cross-sectional profile that is not linear but is, for example, wavy or V-shaped, to enhance the mechanical strength of the fireproof partition 100. Preferably, the support board 30 is formed from a steel plate with a thickness of 2 mm.

Step S2: allowing the support board 30 to be sandwiched between the two fireproof boards 20 through a fixing means so as to form the fireproof partition 100. The fixing means is any conventional fixing means that involves, for example, coating an adhesive on two sides of the support board 30 and/or placing the support board 30 between a pair of fireproof boards 20 and then fixing the support board 30 to between the fireproof boards 20 by a combination of a bolt and a threaded insert. Preferably, step S2 involves coating an adhesive on two sides of the support board 30 to allow the support board 30 to be coupled to the fireproof boards 20, then passing the bolt 41 and the threaded insert 42 through the perforations 21, 31 of the fireproof boards 20 and the support board 30 to achieve the fixation thereof.

Step S3: provide a hanging means on an outer side of one of the two fireproof boards 20. The hanging means is disposed on the connection portions 621 of the securing elements 60 additionally disposed or on the support board 30 of the fireproof partition 100.

Preferably, after the support board 30 has been shaped and formed, one side of the support board 30 is incised at some points, and then the incisions are bent to form tabs 33, 34 respectively for functioning as a hanging means, or the tabs 33, 34 are welded to one side of the support board 30 to function as a hanging means. The openings 22 are formed on the fireproof boards 20 and correspond in position to the tabs 33, 34 respectively to allow the tabs 33, 34 to extend outward from the support board 30 and protrude from the fireproof boards 20, allowing the outermost ends of the tabs 33, 34 to protrude from the outer sides 24 of the fireproof boards 20.

The fireproof partition 100 has a plurality of securing elements 60. The securing elements 60 include threaded inserts 61 and bolts 62. Each of the bolts 62 has the connection portion 621. Each of the securing elements 60 includes the bolt 41 and the threaded insert 42 in the fixing means. The bolts 41 and the threaded inserts 42 are passed through the perforations such that the support board 30 is fixedly coupled to the fireproof boards 20. Each of the bolts 41 has the connection portion 621 whereby the fireproof partition 100 is connected to the C-shaped steel bars 70. Each of the securing elements 60 includes components different from the bolt 41 and the threaded insert 42 in the fixing means, and the securing elements 60 are additionally disposed on the fireproof partition 100 as needed after the fireproof partition 100 has been formed through the fixing means.

Step S4: enabling the fireproof partition 100 to engage with a wall semifinished product of a building through the hanging means, allowing the fireproof partition 100 to hang on the wall semifinished product. The wall semifinished product comprises a steel plate 50 and a plurality of C-shaped steel bars 70 connected to the steel plate 50, or comprises the fireproof partition 100' and the building structure component 200 connected to the C-shaped steel bars 70 arranged on one side or two opposing sides of the fireproof partition 100', as shown in FIG. 7 through FIG. 9. One end of each of the C-shaped steel bars 70 is fixedly connected to the steel plate 50. The other end of each of the C-shaped steel bars 70 is provided with the hook 71. The hooks 71 are configured to operate in conjunction with the hanging means such that the fireproof partition 100 hangs on the C-shaped steel bars 70 and thus can be removably connected to the C-shaped steel bars 70. In another embodiment, the hanging means has a wedge-shaped structure corresponding in shape to the hooks 71, and the wedge-shaped structures of the hanging means are inserted into the hooks 71, or the connection portions engage the hooks 71. In another embodiment, after the sound-insulating material 80 has been placed in between the C-shaped steel bars 70 of the wall semifinished product, the fireproof partition 100 hangs on the wall semifinished product through the hanging means.

## Claims

1. A fireproof partition (100; 100'), comprising:
two fireproof boards (20) made of a fireproof material;
a support board (30) disposed between the two fireproof boards (20);
a fixing means (21, 31) for fixing the two fireproof boards (20) to two opposing sides of the support board (30) respectively, allowing the support board (30) to be sandwiched between the two fireproof boards (20); and
a hanging means (33, 34, 62) provided on an outer side of one of the two fireproof boards (20) and adapted to operate in conjunction with a building.

2. The fireproof partition (100; 100') of claim 1, wherein the support board (30) has a non-planar surface.

3. The fireproof partition (100; 100') of claim 1, wherein the fixing means (21, 31) involves coating an adhesive on the two opposing sides of the support board (30), allowing the support board (30) to be coupled to and fixed to the two fireproof boards (20).

4. The fireproof partition (100; 100') of claim 3, wherein each of the two fireproof boards (20) has an inner side (23) and an outer side (24), with the inner sides (23) facing the support board (30) and being of greater roughness than the outer sides (24).

5. The fireproof partition (100; 100') of claim 1, wherein each of the two fireproof boards (20) and the support board (30) has a plurality of perforations (21, 31), and the fixing means (21, 31) allows the support board (30) to be coupled to and fixed to the two fireproof boards (20) through multiple fastening elements that engage with the perforations (21) of the two fireproof boards (20) and the perforations (31) of the support board (30).

6. The fireproof partition (100; 100') of claim 5, wherein the fastening elements include a bolt (41) and a threaded insert (42), and an end of the bolt (41) is provided with the hanging means.

7. The fireproof partition (100; 100') of claim 1, wherein one of the two fireproof boards (20) has an opening (22), with the hanging means (33, 34, 62) being provided to the support board (30) and exposed from the fireproof board (20) through the opening (22), allowing the hanging means (33, 34, 62) to operate in conjunction with the building.

8. The fireproof partition (100; 100') of claim 1, further comprising a plurality of securing elements disposed on the fireproof partition (100; 100'), the securing elements including a bolt (62) and a threaded insert (61), with the hanging means (621) being provided to an end of the bolt (62) to operate in conjunction with the building.

9. A method of installing a fireproof partition (100; 100'), the method comprising the steps of:
providing a support board (30) and two fireproof boards (20), allowing the support board (30) to be sandwiched between the two fireproof boards (20) through a fixing means (21, 31) so as to form a fireproof partition (100; 100');
providing a hanging means (33, 34, 62) on an outer side (24) of one of the two fireproof boards (20); and
enabling the fireproof partition (100; 100') to engage with a wall semifinished product of a building through the hanging means (33, 34, 62), allowing the fireproof partition (100; 100') to hang on the wall semifinished product.

10. The method of claim 9, wherein the wall semifinished product includes a steel plate and a plurality of C-shaped steel bars (70) connected to the steel plate (50), the method further comprising the step of providing a hook (71) at an end of each of the C-shaped steel bars (70), with the hooks (71) being configured to operate in conjunction with the hanging means (33, 34, 62) to allow the fireproof partition (100; 100') to hang on the C-shaped steel bars (70).

11. The method of claim 9, further comprising the step of providing a plurality of securing elements functioning as the hanging means (33, 34, 62) and disposed on an outer side (24) of one of the two fireproof boards (20).

12. The method of claim 9, wherein an opening (22) is formed on one of the two fireproof boards (20), and the hanging means (33, 34, 62) is exposed from the fireproof board (20) through the opening (22).

13. The method of claim 9, wherein the fixing means (21, 31) involves coating an adhesive on two opposing sides of the support board (30), allowing the support board (30) to be coupled to and fixed to the two fireproof boards (20).

14. The method of claim 9, wherein the fixing means (21, 31) involves providing a plurality of fastening elements, allowing the support board (30) to be coupled to and fixed to the two fireproof boards (20).

15. The method of claim 9, further comprising the step of placing a sound-insulating material (80) between two of the C-shaped steel bars (70) of the wall semifinished product before hanging the fireproof partition (100; 100') on the wall semifinished product.
